# EUROPEAN PATENT APPLICATION

(11) **EP 4 135 144 A1**
(43) Date of publication of application: **15.02.2023**
(21) Application number: 20942556.0
(22) Date of filing: 10.09.2020
(51) Int. Cl.: H02J 3/01

(54) **WIND TURBINE GENERATOR GROUP, AND CONVERTER FILTER CAPACITOR SWITCHING CONTROL METHOD, APPARATUS, AND SYSTEM THEREFOR**

(30) Priority: 29.06.2020 CN 202010602986
(71) Applicant: Beijing Goldwind Science & Creation Windpower Equipment Co. Ltd., Beijing 100176 (CN)
(72) Inventor: CHEN, Liquan, Beijing 100176 (CN); DUAN, Liaoran, Beijing 100176 (CN)
(74) Representative: Gulde & Partner
(86) International application number: PCT/CN2020/114588
(87) International publication number: WO 2022/000785

(57) **Abstract**

The present application provides a wind turbine and a converter filter capacitor switching control method, device and system therefor, and relates to the technical field of wind power generation. The method includes: acquiring (S101, S201, S301) a contactor delay influence factor of the converter and an approximate zero voltage period of the power grid (G10) connected to the wind turbine, wherein an absolute value of a voltage of the power grid (G10) in the approximate zero voltage period is less than an approximate zero voltage threshold; obtaining (S102, S202, S302) a contactor delay duration according to the contactor delay influence factor, wherein the contactor delay duration is a duration from when the contactor (K10) receives a switching instruction to when the contactor (K10) is switched on or off; determining (S103, S203, S303) a switching time point of the filter capacitor (C1, C2, C3) based on the approximate zero voltage period and the contactor delay duration; transmitting (S104, S204, S304) the switching instruction to the contactor (K10) when the switching time point is reached, so that a time point of the contactor (K10) being switched on or off is within the approximate zero voltage period. Using the technical solution of the present application can reduce the risk of failure of the wind turbine.

## Description

### CROSS-REFERENCE TO RELATED APPLICATION

This application claims priority to Chinese Patent Application No. 202010602986.5 entitled "FILTER CAPACITOR SWITCHING CONTROL METHOD, DEVICE AND SYSTEM FOR CONVERTER OF WIND TURBINE" and filed on June 29, 2020, which is incorporated herein by reference in its entirety.

### TECHNICAL FIELD

The present application relates to a technical field of wind power generation, and in particular to a wind turbine and a converter filter capacitor switching control method, device and system therefor.

### BACKGROUND

In order to ensure that the quality of the electric energy output by the wind turbine can meet the requirements of the power grid, the full power converter of the wind turbine is provided with a filter on the power grid side. This filter filters out current harmonics on the power grid side. In particular, the filter may have an LCL structure, that is, the filter includes a leakage inductance of a box-type substation, a filter capacitor and a reactor.

Under a condition that the wind turbine is started, the filter capacitor is switched on. Under a condition that the wind turbine is in standby, the filter capacitor is switched off to reduce the power consumption of the wind turbine. The controller can issue instructions to control the three-phase contactor to be switched on or off, thereby controlling the filter capacitor to be switched on or off. However, when the filter capacitor is being switched on or off, the three-phase contactor may subject to the impact of a large current, and the large current can even reach dozens of times the rated current of the three-phase contactor. Under the impact of the large current, the performance of the three-phase contactor will be affected, thereby increasing the risk of failure of the wind turbine.

### SUMMARY

The embodiments of the present application provide a wind turbine and a converter filter capacitor switching control method, device and system therefor, which can reduce the risk of failure of the wind turbine.

In a first aspect, the embodiments of the present application provide a filter capacitor switching control method for a converter of a wind turbine, wherein the converter includes a filter capacitor and a contactor, the filter capacitor is connected to three phases of a power grid through the contactor, and the method includes: acquiring a contactor delay influence factor of the converter and an approximate zero voltage period of the power grid connected to the wind turbine, wherein an absolute value of a voltage of the power grid in the approximate zero voltage period is less than an approximate zero voltage threshold; obtaining a contactor delay duration according to the contactor delay influence factor, wherein the contactor delay duration is a duration from when the contactor receives a switching instruction to when the contactor is switched on or off; determining a switching time point of the filter capacitor based on the approximate zero voltage period and the contactor delay duration; transmitting the switching instruction to the contactor when the switching time point is reached, so that a time point of the contactor being switched on or off is within the approximate zero voltage period.

In some possible embodiments, the contactor delay influence factor includes one or more of an ambient temperature of the contactor, an ambient humidity of the contactor, a contactor delay duration when the filter capacitor is switched last time, and the voltage of the power grid.

In some possible embodiments, obtaining the contactor delay duration according to the contactor delay influence factor includes: obtaining the contactor delay duration according to one or more contactor delay influence factors and influence delays corresponding to the one or more contactor delay influence factors.

In some possible embodiments, determining the switching time point of the filter capacitor based on the approximate zero voltage period and the contactor delay duration includes: determining a target time point within the approximate zero voltage period; determining the switching time point based on the target time point and the contactor delay duration.

In some possible embodiments, the switching instruction includes a switching on instruction, the switching on instruction is configured to control the contactor to be switched on, the contactor delay duration is a duration from when the contactor receives the switching on instruction to when the contactor is switched on, the switching time point includes a switching on time point, wherein the filter capacitor is switched on under a condition that the contactor is switched on; after transmitting the switching instruction to the contactor, the method further includes: obtaining a first time point when a current of the filter capacitor appears; updating the contactor delay influence factor required to obtain the contactor delay duration next time based on an interval duration between the first time point and the switching on time point.

In some possible embodiments, the switching instruction includes a switching off instruction, the switching off instruction is configured to control the contactor to be switched off, the contactor delay duration is a duration from when the contactor receives the switching off instruction to when the contactor is switched off, the switching time point includes a switching off time point, wherein the filter capacitor is switched off under a condition that the contactor is switched off; after transmitting the switching instruction to the contactor, the method further includes: obtaining a second time point when a current of the filter capacitor disappears; updating the contactor delay influence factor required to obtain the contactor delay duration next time based on an interval duration between the second time point and the switching off time point.

In some possible embodiments, the contactor is a single-phase contactor; the single-phase contactor is configured to control the filter capacitor connected to the single-phase contactor to be switched on or off.

In a second aspect, the embodiments of the present application provide a filter capacitor switching control device for a converter of a wind turbine, wherein the converter includes a filter capacitor and a contactor, the filter capacitor is connected to three phases of a power grid through the contactor, and the device includes: an acquisition module configured to acquire a contactor delay influence factor of the converter and an approximate zero voltage period of the power grid connected to the wind turbine, wherein an absolute value of a voltage of the power grid in the approximate zero voltage period is less than an approximate zero voltage threshold; a first calculation module configured to obtain a contactor delay duration according to the contactor delay influence factor, wherein the contactor delay duration is a duration from when the contactor receives a switching instruction to when the contactor is switched on or off; a second calculation module configured to determine a switching time point of the filter capacitor based on the approximate zero voltage period and the contactor delay duration; a transmission module configured to transmit the switching instruction to the contactor when the switching time point is reached, so that a time point of the contactor being switched on or off is within the approximate zero voltage period.

In a third aspect, the embodiments of the present application provide a filter capacitor switching control system for a converter of a wind turbine, wherein the converter includes a filter capacitor and a contactor, the filter capacitor is connected to three phases of a power grid through the contactor, and the system includes: a first sensor configured to collect a contactor delay influence factor of the converter; a controller connected to the first sensor, wherein the controller is configured to: acquire the contactor delay influence factor and an approximate zero voltage period of the power grid connected to the wind turbine, wherein an absolute value of a voltage of the power grid in the approximate zero voltage period is less than an approximate zero voltage threshold; obtain a contactor delay duration according to the contactor delay influence factor, wherein the contactor delay duration is a duration from when the contactor receives a switching instruction to when the contactor is switched on or off; determine a switching time point of the filter capacitor based on the approximate zero voltage period and the contactor delay duration; transmit the switching instruction to the contactor when the switching time point is reached, so that a time point of the contactor being switched on or off is within the approximate zero voltage period.

In some possible embodiments, the contactor delay influence factor includes one or more of an ambient temperature of the contactor, an ambient humidity of the contactor, a contactor delay duration when the filter capacitor is switched last time, and the voltage of the power grid; the first sensor includes at least one of a temperature sensor, a humidity sensor, and a voltage sensor; the system further includes a current sensor, and the current sensor is arranged on a wire connected with the filter capacitor.

In a fourth aspect, the embodiments of the present application provide a wind turbine comprising the filter capacitor switching control system for the converter of the wind turbine in the third aspect.

Embodiments of the present application provide a wind turbine and a converter filter capacitor switching control method, device and system therefor. According to the contactor delay influence factor, the duration from when the contactor receives the switching instruction to when the contactor is switched on or off may be obtained. Based on the obtained contactor delay duration and the approximate zero voltage period within which the absolute value of the voltage of the power grid is less than the approximate zero voltage threshold, the switching time point of the filter capacitor may be determined. When the switching time point is reached, the switching instruction may be transmitted to the contactor, so that the time point of the contactor being switched on or off is within the approximate zero voltage period. Since the absolute value of the voltage of the power grid in the approximate zero voltage period is less than the approximate zero voltage threshold, the time point of the contactor being switched on or off is within the approximate zero voltage period. Therefore, when the contactor is being switched on or off, the contactor can be prevented from the impact of large current caused by high voltage of the power grid, and thus the contactor can be prevented from being damaged. Therefore, the risk of failure of the contactor may be reduced, and then the risk of failure of the wind turbine may be reduced.

### BRIEF DESCRIPTION OF THE DRAWINGS

The present application will be better understood from the following detailed description of non-limiting embodiments of the present application with reference to the accompanying drawings. Here, like or similar reference numerals indicate like or similar features.
Fig. 1 is a schematic structural diagram of an example of a converter of a wind turbine connecting with a power grid according to an embodiment of the present application;
Fig. 2 is a flowchart of an embodiment of a filter capacitor switching control method for a converter of a wind turbine according to a first aspect of the present application;
Fig. 3 is a schematic diagram of an example of a voltage of a power grid changing with time according to an embodiment of the present application;
Fig. 4 is a flowchart of another embodiment of the filter capacitor switching control method for the converter of the wind turbine according to the first aspect of the present application;
Fig. 5 is a flowchart of an example of a filter capacitor switching on control method for a converter of a wind turbine according to an embodiment of the present application;
Fig. 6 is a flowchart of an example of a filter capacitor switching off control method for a converter of a wind turbine according to an embodiment of the present application;
Fig. 7 is a schematic structural diagram of an embodiment of a filter capacitor switching control device for a converter of a wind turbine according to a second aspect of the present application;
Fig. 8 is a schematic structural diagram of another embodiment of the filter capacitor switching control device for the converter of the wind turbine according to the second aspect of the present application;
Fig. 9 is a schematic structural diagram of another embodiment of the filter capacitor switching control device for the converter of the wind turbine according to the second aspect of the present application;
Fig. 10 is a schematic structural diagram of an embodiment of a filter capacitor switching control system for a converter of a wind turbine according to a third aspect of the present application;
Fig. 11 is a schematic structural diagram of another embodiment of the filter capacitor switching control system for the converter of the wind turbine according to the third aspect of the present application.

### DETAILED DESCRIPTION

The features and exemplary embodiments of various aspects of the present application will be described in detail below. In the following detailed description, numerous specific details are set forth in order to provide a thorough understanding of the present application. However, it will be apparent to those skilled in the art that the present application may be practiced without some of these specific details. The following description of the embodiments is merely intended to provide a better understanding of the present application by illustrating examples of the present application. The present application is by no means limited to any specific configuration and algorithm proposed below, but covers any modification, replacement and improvement of elements, components and algorithms without departing from the spirit of the present application. In the drawings and the following description, at least some of the well-known structures and techniques are not shown in order to avoid unnecessarily obscuring the present application.

With the development of the wind power generation technology, the requirements for the quality of the electric energy of the wind turbine are becoming higher and higher. The wind turbine can be equipped with a converter, the converter includes a filter, and the filter can filter out the current harmonics on the power grid side. Therefore, the electric energy of the wind turbine can meet the requirements of the power grid, so that the wind turbine can be connected to the power grid. In particular, the filter may have an LCL structure, that is, the filter includes a leakage inductance of a box-type substation, a filter capacitor and a reactor. The converter includes a contactor, and the filter capacitor is connected to three phases of the power grid through the contactor.

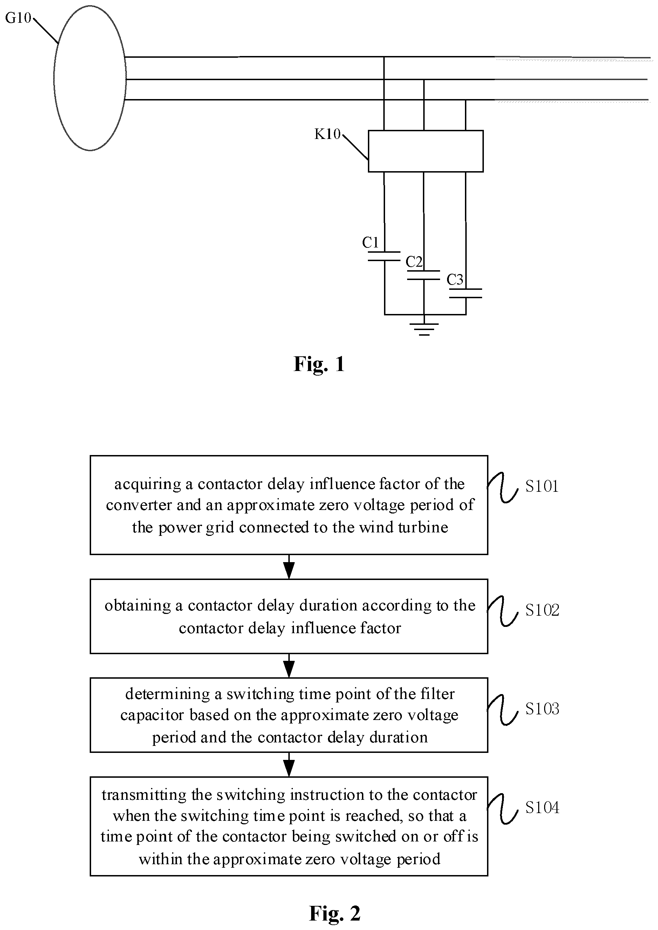

For example, Fig. 1 is a schematic structural diagram of an example of a converter of a wind turbine connecting with a power grid according to an embodiment of the present application. As shown in Fig. 1, the converter includes filter capacitors C1, C2 and C3, and a contactor K10. The filter capacitors C1, C2 and C3 are connected to three phases of the power grid G10 through the contactor K10. Under a condition that the wind turbine is started, the contactor K10 is controlled to be switched on, and the circuit between the filter capacitors C1, C2 and C3 and the power grid G10 is switched on, so that the filter capacitors C1, C2 and C3 are switched on. Under a condition that the wind turbine is in standby, the contactor K10 is controlled to be switched off, and the circuit between the filter capacitors C1, C2 and C3 and the power grid G10 is switched off, so that the filter capacitors C1, C2 and C3 are switched off.

Under a condition that the contactor of the converter receives the switching instruction, the switching on or off action indicated by the switching instruction may not be immediately successfully performed. Nevertheless, after a delay duration, the switching on or off action indicated by the switching instruction may be successfully performed. It is difficult to estimate the delay duration. In the process of controlling the filter capacitor to be switched on or off by controlling the contactor to be switched on or off according to the switching instruction, the contactor may subject to the impact of large current transmitted by the power grid. Therefore, the life of the contactor may be affected, failure of the contactor may be caused, and failure of the wind turbine may be caused.

The embodiments of the present application provide a filter capacitor switching control method, device and system for a converter of a wind turbine, which can control the time when the contactor is actual switched on or off to be within the time period when the voltage of the power grid is low. Therefore, the contactor can be prevented from being impacted by large current, and the risk of failure of the contactor and the wind turbine may be reduced.

Fig. 2 is a flowchart of an embodiment of a filter capacitor switching control method for a converter of a wind turbine according to a first aspect of the present application. As shown in Fig. 2, the filter capacitor switching control method may include steps S101 to S104.

Step S101: acquiring a contactor delay influence factor of the converter and an approximate zero voltage period of the power grid connected to the wind turbine.

The contactor delay influence factor is a factor that affects the duration from when the contactor receives a switching instruction to when the switching on or off action indicated by the switching instruction is actual performed. In some examples, the contactor delay influence factor includes one or more of an ambient temperature of the contactor, an ambient humidity of the contactor, a contactor delay duration when the filter capacitor is switched last time, and the voltage of the power grid.

The ambient temperature of the contactor is the temperature of the environment where the contactor is located. The ambient humidity of the contactor is the humidity of the environment where the contactor is located. The contactor delay duration when the filter capacitor is switched last time is the duration from when the contactor receives the switching instruction last time to when the contactor is switched on or off last time. The voltage of the power grid may specifically be an AC voltage on the power grid side. The contactor delay influence factor is not limited to the above influence factors, and may also include other influence factors affecting the contactor delay duration, which is not limited here.

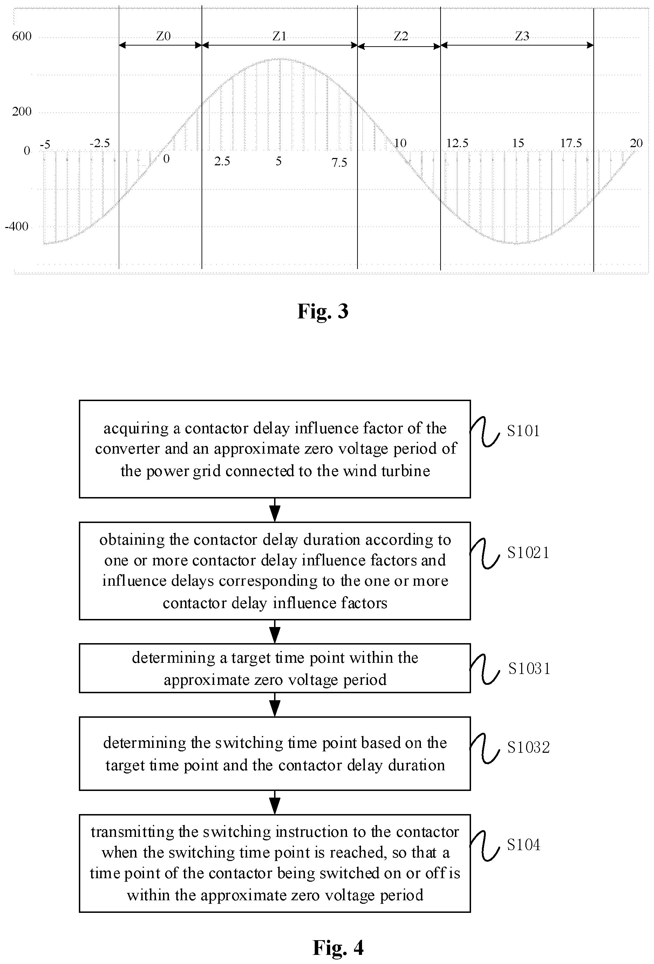

The absolute value of the voltage of the power grid in the approximate zero voltage period is less than an approximate zero voltage threshold. That is, the approximate zero voltage period is the time period when the absolute value of the voltage of the power grid is less than the approximate zero voltage threshold. The approximate zero voltage threshold can be set according to specific working scenarios and working requirements, which is not limited here. For example, Fig. 3 is a schematic diagram of an example of a voltage of a power grid changing with time according to an embodiment of the present application. As shown in Fig. 3, the abscissa represents time, in milliseconds; the ordinate represents the voltage of the power grid, in volts V The voltage zero approximation threshold is set to 250V. Correspondingly, Z0 and Z2 in the figure are the approximate zero voltage period.

Step S102: obtaining a contactor delay duration according to the contactor delay influence factor.

The contactor delay duration is a duration from when the contactor receives a switching instruction to when the contactor is switched on or off. For example, under a condition that there is 2 seconds between the moment when the contactor receives the switching instruction and the moment when the contactor is actually switched on or off, the contactor delay duration is 2 seconds.

There is a corresponding relationship between the contactor delay influence factor and the contactor delay duration. The contactor delay duration varies with the contactor delay influence factor. Therefore, the specific contactor delay duration can be determined according to the contactor delay influence factor. The corresponding relationship between the contactor delay influence factor and the contactor delay duration can be obtained by means of machine learning or multiple tests, which is not limited here.

Step S103: determining a switching time point of the filter capacitor based on the approximate zero voltage period and the contactor delay duration.

The switching time point of the filter capacitor is the time point when the switching instruction is transmitted to the contactor. The switching time point of the filter capacitor can be determined based on a time point in the approximate zero voltage period and the contactor delay duration obtained in the above step, so that a time point obtained by the switching time point of the filter capacitor plus the contactor delay duration is within the approximate zero voltage period.

Step S 104: transmitting the switching instruction to the contactor when the switching time point is reached, so that a time point of the contactor being switched on or off is within the approximate zero voltage period.

When the switching time point is reached, the switching instruction is transmitted to the contactor. After receiving the switching instruction, and after the contactor delay duration, the contactor is switched on or off. Therefore, the time point when the contactor is actually switched on or off is within the approximate zero voltage period. Thus, when the contactor is being switched on or off, the contactor can be prevented from the impact of large current caused by high voltage of the power grid.

In some examples, the contactor in the above embodiments may specifically be a single-phase contactor. The single-phase contactor can be configured to control the filter capacitor connected to the single-phase contactor to be switched on or off. The number and connection mode of the single-phase contactors can be determined according to the connection mode of the filter capacitor, which is not limited here. For example, the number of filter capacitors is three, and each filter capacitor is connected to one phase of the power grid; under a condition that the filter capacitors are connected in a star connection, three single-phase contactors can be set, and each filter capacitor is correspondingly connected to one single-phase contactor. For another example, the number of filter capacitors is three, and each filter capacitor is connected to one phase of the power grid; under a condition that the filter capacitors are connected in a delta connection, two single-phase contactors can be set, and the two single-phase contactors can be respectively set between any two connected filter capacitors. The single-phase contactor can realize the independent control of switching on or off each filter capacitor, which increases the flexibility of the control of switching on or off the filter capacitor.

In the embodiments of the present application, according to the contactor delay influence factor, the duration from when the contactor receives the switching instruction to when the contactor is switched on or off may be obtained. Based on the obtained contactor delay duration and the approximate zero voltage period within which the absolute value of the voltage of the power grid is less than the approximate zero voltage threshold, the switching time point of the filter capacitor may be determined. When the switching time point is reached, the switching instruction may be transmitted to the contactor, so that the time point of the contactor being switched on or off is within the approximate zero voltage period. Since the absolute value of the voltage of the power grid in the approximate zero voltage period is less than the approximate zero voltage threshold, the time point of the contactor being switched on or off is within the approximate zero voltage period. Therefore, when the contactor is being switched on or off, the contactor can be prevented from the impact of large current caused by high voltage of the power grid, and thus the contactor can be prevented from being damaged. Therefore, the risk of failure of the contactor may be reduced, and then the risk of failure of the wind turbine may be reduced.

Fig. 4 is a flowchart of another embodiment of the filter capacitor switching control method for the converter of the wind turbine according to the first aspect of the present application. The difference between Fig. 4 and Fig. 2 is that step S102 in Fig. 2 may be specifically refined into step S 1021 in Fig. 4, and step S103 in Fig. 2 may be specifically refined into steps S1031 and S1032 in Fig. 4.

Step S1021: obtaining the contactor delay duration according to one or more contactor delay influence factors and influence delays corresponding to the one or more contactor delay influence factors.

In the embodiments of the present application, there may be one contactor delay influence factor, or there may be two or more contactor delay influence factors. Each contactor delay influence factor can correspond to an influence delay. The influence delay corresponding to the contactor delay influence factor is the interval time affected by the contactor delay influence factor from when the contactor receives the switching instruction to when the contactor is switched on or off.

In some examples, under a condition that there is one contactor delay influencing factor, the influence delay corresponding to the contactor delay influencing factor may be used as the contactor delay duration.

In other examples, under a condition that there may be two or more contactor delay influence factors, the influence delay corresponding to each contactor delay influence factor can be obtained. Further, the influence delays corresponding to the two or more contactor delay influence factors may be integratedly calculated based on an integration algorithm, and the calculation result of the integrated calculation may be used as the contactor delay duration. The integration algorithm is not limited here. For example, the influence delays corresponding to the two or more contactor delay influence factors may be added and calculated, and the sum of the influence delays corresponding to the two or more contactor delay influence factors may be used as the contactor delay duration. For another example, calculation coefficients can be respectively set for the influence delays corresponding to the two or more contactor delay influence factors, and the sum of the products of the influence delays corresponding to the two or more contactor delay influence factor and the corresponding calculation coefficients may be used as the contactor delay duration.

Step S1031: determining a target time point within the approximate zero voltage period.

Any point in the approximate zero voltage period can be selected as the target time point. In order to ensure that the impact of the current on the contactor is as small as possible, the target time point can be as close as possible to the time point when the voltage of the power grid is zero in the approximate zero voltage period.

Step S1032: determining the switching time point based on the target time point and the contactor delay duration.

The target time point is the time point at which the contactor is expected to be switched on or off. The target time point can be used as the end point, and the contactor delay duration can be used as the interval between the start point and the end point. Therefore, the calculated start point is the switching time point.

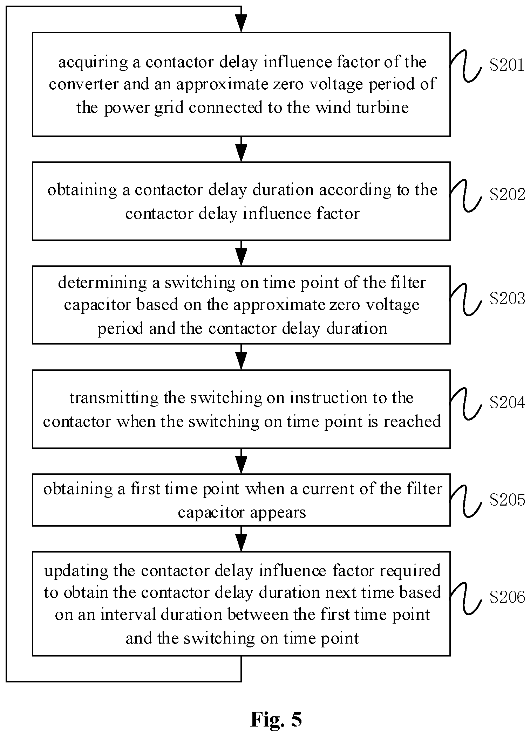

In some examples, the switching instruction in the above embodiments includes a switching on instruction. The switching on instruction is configured to control the contactor to be switched on. The contactor delay duration is a duration from when the contactor receives the switching on instruction to when the contactor is switched on. The switching time point includes a switching on time point. The filter capacitor is switched on under a condition that the contactor is switched on. The filter capacitor switching on control method is a part of the filter capacitor switching control method. The following is an example of controlling the filter capacitor to be switched on. Fig. 5 is a flowchart of an example of a filter capacitor switching on control method for a converter of a wind turbine according to an embodiment of the present application. As shown in Fig. 5, the filter capacitor switching on control method may include steps S201 to S206.

Step S201: acquiring a contactor delay influence factor of the converter and an approximate zero voltage period of the power grid connected to the wind turbine.

Step S202: obtaining a contactor delay duration according to the contactor delay influence factor.

Step S203: determining a switching on time point of the filter capacitor based on the approximate zero voltage period and the contactor delay duration.

Step S204: transmitting a switching on instruction to the contactor when the switching on time point is reached.

Step S205: obtaining a first time point when a current of the filter capacitor appears.

The current of the filter capacitor can be monitored in real time. The appearance of the current in the filter capacitor indicates that the contactor is switched on. The first time point when the current of the filter capacitor appears is recorded, and the first time point can be taken as the time point when the contactor is switched on.

Step S206: updating the contactor delay influence factor required to obtain the contactor delay duration next time based on an interval duration between the first time point and the switching on time point.

The first time point can be used as the time point when the contactor is switched on. Correspondingly, under a condition that the contactor delay influence factor includes the contactor delay duration when the filter capacitor is switched on last time, the interval duration between the first time point and the switching on time point can be used as the contactor delay duration when the filter capacitor is switched on last time. Then, the interval duration may be used to obtain the contactor delay duration next time.

After updating the contactor delay influence factor required to obtain the contactor delay duration next time, steps S201 to S206 can be performed cyclically. Therefore, each switching on of the filter capacitor may be achieved based on the updated contactor delay influence factor and the approximate zero voltage period.

The real-time update of the contactor delay influence factor can improve the accuracy that the time point when the contactor is switched on is within the approximate zero voltage period, thereby further reducing the risk of failure of the contactor and further reducing the risk of failure of the wind turbine.

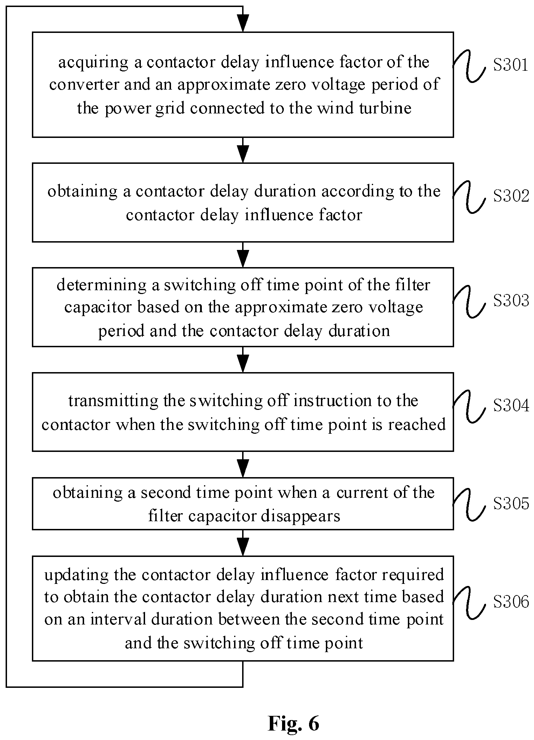

In some other examples, the switching instruction in the above embodiments includes a switching off instruction. The switching off instruction is configured to control the contactor to be switched off. The contactor delay duration is a duration from when the contactor receives the switching off instruction to when the contactor is switched off. The switching time point includes a switching off time point. The filter capacitor is switched off under a condition that the contactor is switched off. The filter capacitor switching off control method is a part of the filter capacitor switching control method. The following is an example of controlling the filter capacitor to be switched off. Fig. 6 is a flowchart of an example of a filter capacitor switching off control method for a converter of a wind turbine according to an embodiment of the present application. As shown in Fig. 6, the filter capacitor switching off control method may include steps S301 to S306.

Step S301: acquiring a contactor delay influence factor of the converter and an approximate zero voltage period of the power grid connected to the wind turbine.

Step S302: obtaining a contactor delay duration according to the contactor delay influence factor.

Step S303: determining a switching off time point of the filter capacitor based on the approximate zero voltage period and the contactor delay duration.

Step S304: transmitting a switching off instruction to the contactor when the switching off time point is reached.

Step S305: obtaining a second time point when a current of the filter capacitor disappears.

The current of the filter capacitor can be monitored in real time. The disappearance of the current in the filter capacitor indicates that the contactor is switched off. The second time point when the current of the filter capacitor disappears is recorded, and the second time point can be taken as the time point when the contactor is switched off.

Step S306: updating the contactor delay influence factor required to obtain the contactor delay duration next time based on an interval duration between the second time point and the switching off time point.

The second time point can be used as the time point when the contactor is switched off. Correspondingly, under a condition that the contactor delay influence factor includes the contactor delay duration when the filter capacitor is switched off last time, the interval duration between the second time point and the switching off time point can be used as the contactor delay duration when the filter capacitor is switched off last time. Then, the interval duration may be used to obtain the contactor delay duration next time.

After updating the contactor delay influence factor required to obtain the contactor delay duration next time, steps S301 to S306 can be performed cyclically. Therefore, each switching off of the filter capacitor may be achieved based on the updated contactor delay influence factor and the approximate zero voltage period.

The real-time update of the contactor delay influence factor can improve the accuracy that the time point when the contactor is switched off is within the approximate zero voltage period, thereby further reducing the risk of failure of the contactor and further reducing the risk of failure of the wind turbine.

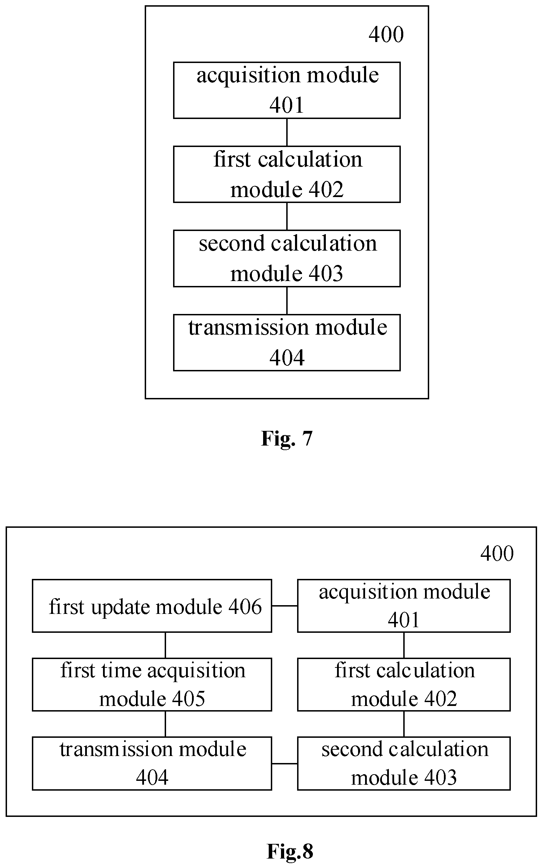

In a second aspect, the embodiments of the present application further provide a filter capacitor switching control device for a converter of a wind turbine. Fig. 7 is a schematic structural diagram of an embodiment of a filter capacitor switching control device for a converter of a wind turbine according to the second aspect of the present application. As shown in Fig. 7, the filter capacitor switching control device 400 may include an acquisition module 401, a first calculation module 402, a second calculation module 403 and a transmission module 404.

The acquisition module 401 may be configured to acquire a contactor delay influence factor of the converter and an approximate zero voltage period of the power grid connected to the wind turbine.

The absolute value of a voltage of the power grid in the approximate zero voltage period is less than an approximate zero voltage threshold;

The first calculation module 402 may be configured to obtain a contactor delay duration according to the contactor delay influence factor.

The contactor delay duration is a duration from when the contactor receives a switching instruction to when the contactor is switched on or off;

The second calculation module 403 may be configured to determine a switching time point of the filter capacitor based on the approximate zero voltage period and the contactor delay duration;

The transmission module 404 may be configured to transmit the switching instruction to the contactor when the switching time point is reached, so that a time point of the contactor being switched on or off is within the approximate zero voltage period.

In the embodiments of the present application, according to the contactor delay influence factor, the duration from when the contactor receives the switching instruction to when the contactor is switched on or off may be obtained. Based on the obtained contactor delay duration and the approximate zero voltage period within which the absolute value of the voltage of the power grid is less than the approximate zero voltage threshold, the switching time point of the filter capacitor may be determined. When the switching time point is reached, the switching instruction may be transmitted to the contactor, so that the time point of the contactor being switched on or off is within the approximate zero voltage period. Since the absolute value of the voltage of the power grid in the approximate zero voltage period is less than the approximate zero voltage threshold, the time point of the contactor being switched on or off is within the approximate zero voltage period. Therefore, when the contactor is being switched on or off, the contactor can be prevented from the impact of large current caused by high voltage of the power grid, and thus the contactor can be prevented from being damaged. Therefore, the risk of failure of the contactor may be reduced, and then the risk of failure of the wind turbine may be reduced.

In some examples, the contactor delay influence factor includes one or more of an ambient temperature of the contactor, an ambient humidity of the contactor, a contactor delay duration when the filter capacitor is switched last time, and the voltage of the power grid.

In some examples, the first calculation module 402 in the above embodiment may be specifically configured to obtain the contactor delay duration according to one or more contactor delay influence factors and influence delays corresponding to the one or more contactor delay influence factors.

In some examples, the second calculation module 403 in the above embodiment may be specifically configured to: determine a target time point within the approximate zero voltage period; and determine the switching time point based on the target time point and the contactor delay duration.

Optionally, the switching instruction includes a switching on instruction. The switching on instruction is configured to control the contactor to be switched on. The contactor delay duration is a duration from when the contactor receives the switching on instruction to when the contactor is switched on. The switching time point includes a switching on time point. The filter capacitor is switched on under a condition that the contactor is switched on.

Fig. 8 is a schematic structural diagram of another embodiment of the filter capacitor switching control device for the converter of the wind turbine according to the second aspect of the present application. The difference between Fig. 8 and Fig. 7 is that the filter capacitor switching control device shown in Fig. 7 may further include a first time acquisition module 405 and a first update module 406.

The first time acquisition module 405 may be configured to obtain a first time point when a current of the filter capacitor appears.

The first update module 406 may be configured to update the contactor delay influence factor required to obtain the contactor delay duration next time based on an interval duration between the first time point and the switching on time point.

Optionally, the switching instruction includes a switching off instruction. The switching off instruction is configured to control the contactor to be switched off. The contactor delay duration is a duration from when the contactor receives the switching off instruction to when the contactor is switched off. The switching time point includes a switching off time point. The filter capacitor is switched off under a condition that the contactor is switched off.

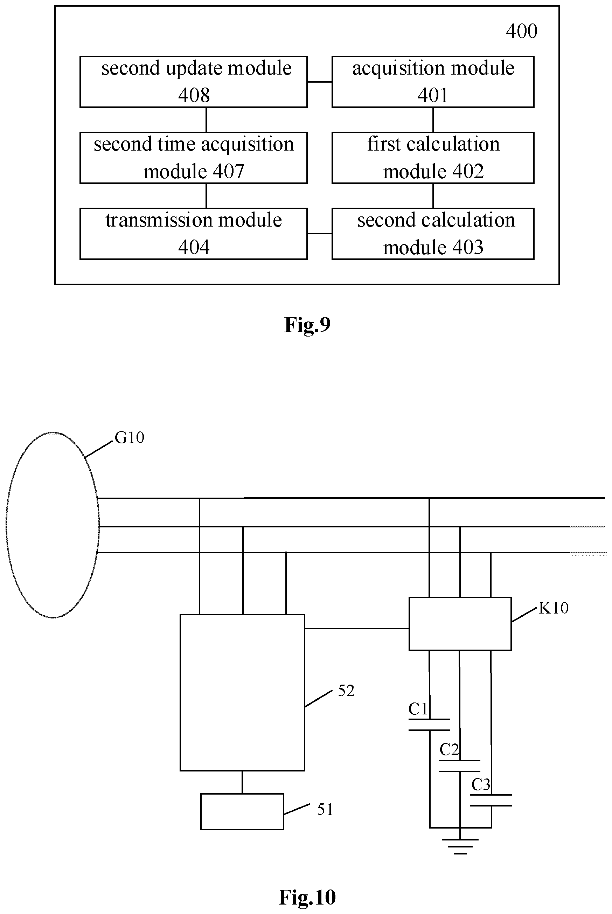

Fig. 9 is a schematic structural diagram of another embodiment of the filter capacitor switching control device for the converter of the wind turbine according to the second aspect of the present application. The difference between Fig. 9 and Fig. 7 is that the filter capacitor switching control device shown in Fig.9 may further include a second time acquisition module 407 and a second update module 408.

The second time acquisition module 407 may be configured to obtain a second time point when a current of the filter capacitor disappears.

The second update module 408 may be configured to update the contactor delay influence factor required to obtain the contactor delay duration next time based on an interval duration between the second time point and the switching off time point.

In a third aspect, the embodiments of the present application further provide a filter capacitor switching control system for a converter of a wind turbine. Fig. 10 is a schematic structural diagram of an embodiment of a filter capacitor switching control system for a converter of a wind turbine according to the third aspect of the present application. As shown in Fig. 10, the filter capacitor switching control system may include a first sensor 51 and a controller 52. The converter of the wind turbine includes filter capacitors C1, C2 and C3, and a contactor K10. The filter capacitors C1, C2 and C3 are respectively connected to three phases of the power grid through the contactor. The controller 52 can be connected to the contactor K10 for controlling the contactor K10 to be switched on or off.

The first sensor 51 may be configured to collect a contactor delay influence factor of the converter.

The controller 52 may be connected to the first sensor 51. The controller 52 may be configured to: acquire the contactor delay influence factor and an approximate zero voltage period of the power grid connected to the wind turbine, wherein an absolute value of a voltage of the power grid in the approximate zero voltage period is less than an approximate zero voltage threshold; obtain a contactor delay duration according to the contactor delay influence factor, wherein the contactor delay duration is a duration from when the contactor receives a switching instruction to when the contactor is switched on or off; determine a switching time point of the filter capacitor based on the approximate zero voltage period and the contactor delay duration; transmit the switching instruction to the contactor when the switching time point is reached, so that a time point of the contactor being switched on or off is within the approximate zero voltage period.

The filter capacitor switching control device 400 for the converter of the wind turbine in the above embodiments can be specifically implemented as the controller 52 in the embodiments of the present application.

In the embodiments of the present application, according to the contactor delay influence factor, the duration from when the contactor receives the switching instruction to when the contactor is switched on or off may be obtained. Based on the obtained contactor delay duration and the approximate zero voltage period within which the absolute value of the voltage of the power grid is less than the approximate zero voltage threshold, the switching time point of the filter capacitor may be determined. When the switching time point is reached, the switching instruction may be transmitted to the contactor, so that the time point of the contactor being switched on or off is within the approximate zero voltage period. Since the absolute value of the voltage of the power grid in the approximate zero voltage period is less than the approximate zero voltage threshold, the time point of the contactor being switched on or off is within the approximate zero voltage period. Therefore, when the contactor is being switched on or off, the contactor can be prevented from the impact of large current caused by high voltage of the power grid, and thus the contactor can be prevented from being damaged. Therefore, the risk of failure of the contactor may be reduced, and then the risk of failure of the wind turbine may be reduced.

In some examples, the filter capacitor switching control system in the above embodiments may further include a converter of the wind turbine. The contactor delay influence factor may include one or more of an ambient temperature of the contactor, an ambient humidity of the contactor, a contactor delay duration when the filter capacitor is switched last time, and the voltage of the power grid. Correspondingly, the first sensor may include at least one of a temperature sensor, a humidity sensor, and a voltage sensor. The contactor may specifically be a single-phase contactor. The single-phase contactor may be configured to control the filter capacitor connected to the single-phase contactor to be switched on or off. The filter capacitor switching control system may also include a current sensor.

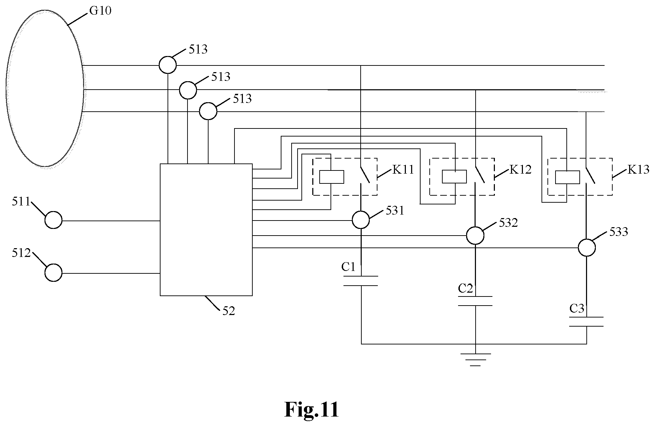

Fig. 11 is a schematic structural diagram of another embodiment of the filter capacitor switching control system for the converter of the wind turbine according to the third aspect of the present application. As shown in Fig. 11, the first sensor 51 may include a temperature sensor 511, a humidity sensor 512 and voltage sensors 513. The temperature sensor may be configured to obtain the ambient temperature of the contactor. The humidity contactor may be configured to obtain the ambient humidity of the contactor. The voltage sensors 513 may be respectively arranged on the three phases of the power grid G10 to obtain the voltage of the power grid G10.

The filter capacitors C1, C2 and C3 are connected in a star connection. The contactor K10 may include single-phase contactors K11, K12 and K13. The filter capacitor C1 is connected to the first phase of the power grid G10 through the single-phase contactor K11, the filter capacitor C2 is connected to the second phase of the power grid G10 through the single-phase contactor K12, and the filter capacitor C3 is connected to the third phase of the power grid G10 through the single-phase contactor K13. The current sensor can be arranged between the filter capacitor and the contactor. As shown in Fig. 11, the current sensor 531 is arranged between the filter capacitor C1 and the single-phase contactor K11, the current sensor 532 is arranged between the filter capacitor C2 and the single-phase contactor K12, and the current sensor 533 is arranged between the filter capacitor C3 and the single-phase contactor K13.

The single-phase contactor has a first terminal, a second terminal, a third terminal and a fourth terminal. The first terminal of the single-phase contactor K11 is connected to the first phase of the power grid G10, and the second terminal of the single-phase contactor K11 is connected to one terminal of the filter capacitor C1. The controller 52 can be connected to the third terminal and the fourth terminal of the single-phase contactor K11, and the controller 52 can transmit a switching instruction to the single-phase contactor K11 to control the single-phase contactor K11 to be switched on or off. The first terminal of the single-phase contactor K12 is connected to the second phase of the power grid G10, and the second terminal of the single-phase contactor K12 is connected to one terminal of the filter capacitor C2. The controller 52 can be connected to the third terminal and the fourth terminal of the single-phase contactor K12, and the controller 52 can transmit a switching instruction to the single-phase contactor K12 to control the single-phase contactor K12 to be switched on or off. The first terminal of the single-phase contactor K13 is connected to the third phase of the power grid G10, and the second terminal of the single-phase contactor K13 is connected to one terminal of the filter capacitor C3. The controller 52 can be connected to the third terminal and the fourth terminal of the single-phase contactor K13, and the controller 52 can transmit a switching instruction to the single-phase contactor K13 to control the single-phase contactor K13 to be switched on or off.

In other examples, the filter capacitors can also be connected in a delta connection. Two single-phase contactors can be correspondingly arranged, and the two single-phase contactors can be respectively arranged between any two connected filter capacitors, which is not repeated here.

In some examples, the controller 52 may be specifically configured to obtain the contactor delay duration according to one or more contactor delay influence factors and influence delays corresponding to the one or more contactor delay influence factors.

In some examples, the controller 52 may be specifically configured to: determine a target time point within the approximate zero voltage period; and determine the switching time point based on the target time point and the contactor delay duration.

Optionally, the switching instruction includes a switching on instruction. The switching on instruction is configured to control the contactor to be switched on. The contactor delay duration is a duration from when the contactor receives the switching on instruction to when the contactor is switched on. The switching time point includes a switching on time point. The filter capacitor is switched on under a condition that the contactor is switched on.

The controller 52 may be further configured to: obtain a first time point when a current of the filter capacitor appears; update the contactor delay influence factor required to obtain the contactor delay duration next time based on an interval duration between the first time point and the switching on time point.

Optionally, the switching instruction includes a switching off instruction. The switching off instruction is configured to control the contactor to be switched off. The contactor delay duration is a duration from when the contactor receives the switching off instruction to when the contactor is switched off. The switching time point includes a switching off time point. The filter capacitor is switched off under a condition that the contactor is switched off.

The controller 52 may be further configured to: obtain a second time point when a current of the filter capacitor disappears; update the contactor delay influence factor required to obtain the contactor delay duration next time based on an interval duration between the second time point and the switching off time point.

According to yet another exemplary embodiment of the present application, a wind turbine is provided. The wind turbine may include the filter capacitor switching control system for the converter of the wind turbine described above. The first sensor in the filter capacitor switching control system for the converter of the wind turbine can be arranged adjacent to the contactor of the converter of the wind turbine, or can be arranged on the wire connecting the converter of the wind turbine and the power grid. The arrangement is not limited here, and can be specifically set according to the function of the first sensor.

In the case where the filter capacitor switching control system for the converter of the wind turbine includes a current sensor, the current sensor can be arranged on the wire connected with the filter capacitor in the converter of the wind turbine, which is not limited here.

The wind turbine and the filter capacitor switching control system for the converter of the wind turbine described above may have corresponding technical effects of the filter capacitor switching control device for the converter of the wind turbine, which will not be repeated here.

It should be clear that the embodiments in this specification are described in a progressive manner, the same or similar parts of the embodiments may be referred to each other, and each embodiment focuses on its difference from other embodiments. For the device embodiments, the system embodiments and the wind turbine embodiments, reference may be made to the description of the method embodiments for relevant parts. The present application is not limited to the specific steps and structures described above and shown in the figures. Those skilled in the art may make various changes, modifications and additions, or change the order between steps, after comprehending the spirit of the present application. Also, for the sake of brevity, detailed descriptions of known methods and techniques are omitted here.

Aspects of the present application are described above with reference to flowcharts and/or block diagrams of methods, devices (systems) and machine program products according to embodiments of the present application. It will be understood that each block of the flowcharts and/or block diagrams, and combinations of blocks of the flowcharts and/or block diagrams, can be implemented by programs or instructions. These programs or instructions may be provided to a processor of a general purpose computer, a special purpose computer, or other programmable data processing device to produce a machine, such that these programs or instructions executed by the processor of the computer or other programmable data processing device can enable implementation of the functions/acts specified in one or more blocks of the flowcharts and/or block diagrams. Such a processor may be, but not limited to, a general purpose processor, a special purpose processor, an application specific processor, or a field programmable logic circuit. It will also be understood that each block of the block diagrams and/or flowcharts, and combinations of blocks of the block diagrams and/or flowcharts, can also be implemented by special purpose hardware for performing specified functions or actions, or can be implemented by a combination of special purpose hardware and computer instructions.

Those skilled in the art will understand that all the above embodiments are exemplary and non-limiting. Different technical features in different embodiments may be combined to achieve beneficial results. Those skilled in the art should be able to understand and implement other varied embodiments of the disclosed ones by studying the drawings, the specification and the claims. In the claims, the term "include" does not exclude other devices and steps; the quantifier "one" does not exclude multiple; the terms "first", "second" are used to indicate a name rather than to specify any particular order. Any reference numerical in the claims should not be construed as limiting the scope of protection. Functions of a plurality of parts in the claims may be implemented by a single hardware or software module. The presence of certain technical features in different dependent claims does not imply that these technical features cannot be combined to achieve beneficial results.

## Claims

1. A filter capacitor switching control method for a converter of a wind turbine, wherein the converter comprises a filter capacitor and a contactor, the filter capacitor is connected to three phases of a power grid through the contactor, and the method comprises:
acquiring a contactor delay influence factor of the converter and an approximate zero voltage period of the power grid connected to the wind turbine, wherein an absolute value of a voltage of the power grid in the approximate zero voltage period is less than an approximate zero voltage threshold;
obtaining a contactor delay duration according to the contactor delay influence factor, wherein the contactor delay duration is a duration from when the contactor receives a switching instruction to when the contactor is switched on or off;
determining a switching time point of the filter capacitor based on the approximate zero voltage period and the contactor delay duration;
transmitting the switching instruction to the contactor when the switching time point is reached, so that a time point of the contactor being switched on or off is within the approximate zero voltage period.

2. The method according to claim 1, wherein the contactor delay influence factor comprises one or more of:
an ambient temperature of the contactor, an ambient humidity of the contactor, a contactor delay duration when the filter capacitor is switched last time, and the voltage of the power grid.

3. The method according to claim 1, wherein obtaining the contactor delay duration according to the contactor delay influence factor comprises:
obtaining the contactor delay duration according to one or more contactor delay influence factors and influence delays corresponding to the one or more contactor delay influence factors.

4. The method according to claim 1, wherein determining the switching time point of the filter capacitor based on the approximate zero voltage period and the contactor delay duration comprises:
determining a target time point within the approximate zero voltage period;
determining the switching time point based on the target time point and the contactor delay duration.

5. The method according to claim 1, wherein the switching instruction comprises a switching on instruction, the switching on instruction is configured to control the contactor to be switched on, the contactor delay duration is a duration from when the contactor receives the switching on instruction to when the contactor is switched on, the switching time point comprises a switching on time point, wherein the filter capacitor is switched on under a condition that the contactor is switched on;
after transmitting the switching instruction to the contactor, the method further comprises:
obtaining a first time point when a current of the filter capacitor appears;
updating the contactor delay influence factor required to obtain the contactor delay duration next time based on an interval duration between the first time point and the switching on time point.

6. The method according to claim 1, wherein the switching instruction comprises a switching off instruction, the switching off instruction is configured to control the contactor to be switched off, the contactor delay duration is a duration from when the contactor receives the switching off instruction to when the contactor is switched off, the switching time point comprises a switching off time point, wherein the filter capacitor is switched off under a condition that the contactor is switched off;
after transmitting the switching instruction to the contactor, the method further comprises:
obtaining a second time point when a current of the filter capacitor disappears;
updating the contactor delay influence factor required to obtain the contactor delay duration next time based on an interval duration between the second time point and the switching off time point.

7. The method according to claim 1, wherein the contactor is a single-phase contactor or a contactor used as a single-phase contactor; the single-phase contactor is configured to control the filter capacitor connected to the single-phase contactor to be switched on or off.

8. A filter capacitor switching control device for a converter of a wind turbine, wherein the converter comprises a filter capacitor and a contactor, the filter capacitor is connected to three phases of a power grid through the contactor, and the device comprises:
an acquisition module configured to acquire a contactor delay influence factor of the converter and an approximate zero voltage period of the power grid connected to the wind turbine, wherein an absolute value of a voltage of the power grid in the approximate zero voltage period is less than an approximate zero voltage threshold;
a first calculation module configured to obtain a contactor delay duration according to the contactor delay influence factor, wherein the contactor delay duration is a duration from when the contactor receives a switching instruction to when the contactor is switched on or off;
a second calculation module configured to determine a switching time point of the filter capacitor based on the approximate zero voltage period and the contactor delay duration;
a transmission module configured to transmit the switching instruction to the contactor when the switching time point is reached, so that a time point of the contactor being switched on or off is within the approximate zero voltage period.

9. A filter capacitor switching control system for a converter of a wind turbine, wherein the converter comprises a filter capacitor and a contactor, the filter capacitor is connected to three phases of a power grid through the contactor, and the system comprises:
a first sensor configured to collect a contactor delay influence factor of the converter;
a controller connected to the first sensor, wherein the controller is configured to: acquire the contactor delay influence factor and an approximate zero voltage period of the power grid connected to the wind turbine, wherein an absolute value of a voltage of the power grid in the approximate zero voltage period is less than an approximate zero voltage threshold; obtain a contactor delay duration according to the contactor delay influence factor, wherein the contactor delay duration is a duration from when the contactor receives a switching instruction to when the contactor is switched on or off; determine a switching time point of the filter capacitor based on the approximate zero voltage period and the contactor delay duration; transmit the switching instruction to the contactor when the switching time point is reached, so that a time point of the contactor being switched on or off is within the approximate zero voltage period.

10. The system according to claim 9, wherein,
the contactor delay influence factor comprises one or more of an ambient temperature of the contactor, an ambient humidity of the contactor, a contactor delay duration when the filter capacitor is switched last time, and the voltage of the power grid;
the first sensor comprises at least one of a temperature sensor, a humidity sensor, and a voltage sensor;
the system further comprises a current sensor, and the current sensor is arranged on a wire connected with the filter capacitor.

11. A wind turbine comprising the filter capacitor switching control system for the converter of the wind turbine according to claim 9 or 10.
